# EUROPEAN PATENT APPLICATION

(11) **EP 4 481 481 A1**
(43) Date of publication of application: **25.12.2024**
(21) Application number: 24164388.1
(22) Date of filing: 19.03.2024
(51) Int. Cl.: G02F 1/03, G02F 1/01, H01S 5/183

(54) **PHASE MODULATION DEVICE AND ELECTRONIC APPARATUS INCLUDING THE SAME**

(30) Priority: 19.06.2023 KR 20230078204
(71) Applicant: Samsung Electronics Co., Ltd., Suwon-si, Gyeonggi-do 16677 (KR)
(72) Inventor: PARK, Junghyun, 16678 Suwon-si (KR); KIM, Sunil, 16678 Suwon-si (KR); LEE, Minkyung, 16678 Suwon-si (KR); JEONG, Byunggil, 16678 Suwon-si (KR)
(74) Representative: Elkington and Fife LLP

(57) **Abstract**

A phase modulation device includes an upper reflective layer onto which incident light is incident; a lower reflective layer provided on a lower portion of the upper reflective layer; an active layer provided between the upper reflective layer and the lower reflective layer; a first electrode connected to an upper surface of the active layer; and a second electrode connected to a lower surface of the active layer, wherein the lower reflective layer may include a first distributed Bragg reflector (DBR) layer including at least one first low refractive material layer and at least one first high refractive material layer that are alternately stacked, the at least one first low refractive material layer has a first refractive index and the at least one first high refractive material layer has a second refractive index that is greater than the first refractive index, and the active layer may include a material having a third refractive index greater than the first refractive index of the at least one first low refractive material layer.

## Description

### FIELD OF THE INVENTION

The disclosure relates to a phase modulation device and an electronic apparatus including the same.

### BACKGROUND OF THE INVENTION

To steer a laser beam to a desired position, a method of mechanically rotating a laser emitting part and a method of using an optical phased array (OPA) may be utilized. The method using the OPA to steer a laser beam by modulating a phase of the laser beam incident on a phase modulation device and emitting the laser beam has been recently receiving attention. A beam steering device using the OPA may be applied to various fields, such, light detection and ranging (LiDAR) devices and three-dimensional (3D) depth cameras that obtain distance information for various directions.

### SUMMARY OF THE INVENTION

Provided are a phase modulation device and an electronic apparatus including the same.

Additional aspects will be set forth in part in the description which follows and, in part, will be apparent from the description, or may be learned by practice of the presented embodiments of the disclosure.

According to an aspect of the disclosure, a phase modulation device includes: an upper reflective layer onto which incident light is incident; a lower reflective layer provided on a lower portion of the upper reflective layer; an active layer provided between the upper reflective layer and the lower reflective layer; a first electrode connected to an upper surface of the active layer; and a second electrode connected to a lower surface of the active layer, wherein the lower reflective layer may include a first distributed Bragg reflector (DBR) layer including at least one first low refractive material layer and at least one first high refractive material layer that are alternately stacked, the at least one first low refractive material layer has a first refractive index and the at least one first high refractive material layer has a second refractive index that is greater than the first refractive index, and the active layer may include a material having a third refractive index greater than the first refractive index of the at least one first low refractive material layer.

Embodiments may, for example, facilitate a compact depth camera for mobile applications using Phased-array-based Beam Steering.

For instance, embodiments relate to a three-dimensional depth camera that acquires distance information by direction. More particularly, embodiments relate to a method for realizing a mechanically immobile beam scanning device using an optical modulation element capable of adjusting the phase of reflection or transmission when reflecting or transmitting irradiated light, and obtaining advantages in terms of optical module configuration, operation, and power consumption.

Embodiments may be utilized to fabricate a phase modulation array in beam steering for a time of flight sensor.

By constructing a cavity region using materials with high refractive index and high thermo-optic coefficient, it may be possible to fabricate a phase modulation device that is robust to changes in the incident angle and has low power consumption. During Si annealing to generate Joule's heat, a SiO2 protection layer may be added to prevent device peel off.

According to a proposed embodiment, there may be provided a reflective phase modulation device comprising a first material having a high refractive index and a high thermo-optic coefficient, a second material having a low refractive index and a low thermo-optic coefficient, and a cavity region between an upper reflector and a lower reflector may comprise the first material. Joule's heat may be generated by applying a voltage or current around the first material, and the resonance condition may change accordingly, and a reflection phase may be modulated for a fixed laser wavelength according to the change in the resonance condition.

The active layer may include a material having a first thermo-optic coefficient that is greater than a second thermo-optic coefficient of the at least one first low refractive material layer.

The phase modulation device may be configured to change a refractive index of the active layer based on a current injected into the active layer through the first and second electrodes.

The active layer may include Si or Ge.

A thickness of the active layer may be greater than a thickness of the at least one first high refractive material layer.

The upper reflective layer may include a high contrast grating (HCG) layer.

The upper reflective layer may include a second DBR layer, the second DBR layer may include at least one second low refractive material layer and at least one second high refractive material layer that are alternately stacked, and the at least one second low refractive material layer may have a fourth refractive index and the at least one second high refractive material layer may have a fifth refractive index that is greater than the fourth refractive index.

A number of alternately stacked layers in the second DBR layer may be less than a number of alternately stacked layers in the first DBR layer.

The phase modulation device may further include a protection layer provided between the upper reflective layer and the active layer.

The protection layer may include at least one of silicon oxide, silicon nitride, aluminum oxide, hafnium oxide, and titanium oxide.

A thickness of the protection layer may be in a range of about 20 nm to about 200 nm.

A wavelength of the incident light may be in a range of about 900 nm to about 1,000 nm.

According to an aspect of the disclosure, a phase modulation device includes: a first distributed Bragg reflector (DBR) layer including at least one first layer and at least one second layer that are alternately stacked, the at least one first layer including a first low refractive index material having a first refractive index, the at least one second layer including a first high refractive index material having a second refractive index that is greater than the first refractive index; a third layer provided on the first DBR layer, the third layer having a third refractive index that is greater than the first refractive index, and having a thickness that is greater than a thickness of the at least one second layer; a first electrode connected to an upper surface of the third layer; and a second electron connected to a lower surface of the third layer.

The third layer may have a first thermo-optic coefficient that is greater than a second thermo-optic coefficient of the first low refractive index material of the at least one first layer.

The third layer may include Si or Ge.

The phase modulation device may further include a protection layer provided on the third layer.

The phase modulation device may further include a high contrast grating (HCG) layer provided on the third layer.

The phase modulation device may further include a second DBR layer provided on the third layer, the second DBR layer may include at least one fourth layer and at least one fifth layer that are alternately stacked, the at least one fourth layer may include a second low refractive index material having a fourth refractive index, and the at least one fifth layer may include a second high refractive index material having a fifth refractive index that is greater than the fourth refractive index.

According to an aspect of the disclosure, an electronic apparatus includes: a laser light source configured to emit light of a predetermined wavelength; and a phase modulation device configured to modulate a phase of the light of the predetermined wavelength that is incident thereon from the laser light source, wherein the phase modulation device includes: an upper reflective layer onto which the light of the predetermined wavelength is incident; a lower reflective layer provided on a lower portion of the upper reflective layer; an active layer provided between the upper reflective layer and the lower reflective layer; a first electrode connected to an upper surface of the active layer; and a second electrode connected a lower surface of the active layer, wherein the lower reflective layer may include a first distributed Bragg reflector (DBR) layer including at least one first low refractive material layer and at least one first high refractive material layer that are alternately stacked, the at least one first low refractive material layer has a first refractive index and the at least one first high refractive material layer has a second refractive index that is greater than the first refractive index, and the active layer may include a material having a third refractive index greater than the first refractive index of the at least one first low refractive material layer.

The predetermined wavelength may be in a range of about 900 nm to about 1,000 nm.

### BRIEF DESCRIPTION OF DRAWINGS

The above and other aspects, features, and advantages of certain embodiments of the disclosure will be more apparent from the following description taken in conjunction with the accompanying drawings, in which:
FIG. 1 is a perspective view illustrating a phase modulation device according to an embodiment;
FIG. 2A is a perspective view illustrating a pixel of the phase modulation device shown in FIG. 1 according to an embodiment;
FIG. 2B is a cross-sectional view taken along a line I-I' of FIG. 2A according to an embodiment;
FIG. 3A is a perspective view illustrating a phase modulation device according to an embodiment;
FIG. 3B is a cross-sectional view taken along a line II-II' of FIG. 3A according to an embodiment;
FIG. 4A illustrates a phase modulation device according to a first comparative example;
FIG. 4B illustrates a phase modulation device according to a second comparative example;
FIG. 5A illustrates the phase modulation device according to the second comparative example;
FIG. 5B is a graph illustrating a reflectance spectrum according to a change in an incidence angle of an incident beam incident on the phase modulation device according to the second comparative example;
FIG. 6A illustrates a phase modulation device according to an embodiment;
FIG. 6B is a graph illustrating a reflectance spectrum according to a change in an incidence angle of an incident beam incident on the phase modulation device, according to an embodiment;
FIG. 7A is a diagram illustrating a region in which a refractive index highly changes due to heating in the phase modulation device according to the first comparative example;
FIG. 7B is a diagram illustrating a region in which a refractive index highly changes due to heating in the phase modulation device according to an embodiment;
FIG. 8A is a graph illustrating simulation results regarding a reflectance of an SiO₂ active layer according to an applied voltage in the phase modulation device according to the first comparative example;
FIG. 8B is a graph illustrating simulation results regarding a reflectance of a Si active layer according to an applied voltage in the phase modulation device according to an embodiment;
FIG. 9A is a graph illustrating simulation results regarding a reflection phase of the SiO₂ active layer according to the applied voltage in the phase modulation device according to the first comparative example;
FIG. 9B is a graph illustrating simulation results regarding a reflection phase of the Si active layer according to the applied voltage in the phase modulation device according to an embodiment;
FIG. 10A is a graph illustrating simulation results regarding a reflection phase change in the SiO₂ active layer in the phase modulation device according to the first comparative example;
FIG. 10B is a graph illustrating simulation results regarding a reflection phase change in the Si active layer according to the applied voltage in the phase modulation device according to an embodiment;
FIG. 11A is a graph illustrating simulation results regarding a temperature distribution for each grating element position of a high contrast grating (HCG) layer in the phase modulation device according to the first comparative example;
FIG. 11B is a graph illustrating simulation results regarding a temperature distribution for each grating element position of an HCG layer in the phase modulation device according to an embodiment;
FIG. 12 is a graph illustrating experiment results regarding a comparison of a resonance wavelength shift according to the applied voltage between the SiO₂ active layer of the phase modulation device according to the first comparative example and the Si active layer of the phase modulation device according to an embodiment;
FIG. 13 is a graph illustrating experimental results regarding a phase spectrum and a reflectance spectrum of the phase modulation device according to an embodiment;
FIG. 14 is a graph illustrating a far-field distribution measured through beam steering in the phase modulation device according to an embodiment;
FIG. 15 is a cross-sectional view illustrating a phase modulation device according to an embodiment;
FIG. 16 is a cross-sectional view illustrating a phase modulation device according to an embodiment; and
FIG. 17 is a diagram illustrating a beam steering system according to an embodiment.

### DETAILED DESCRIPTION

Reference will now be made in detail to embodiments, examples of which are illustrated in the accompanying drawings, wherein like reference numerals refer to like elements throughout. In this regard, the present embodiments may have different forms and should not be construed as being limited to the descriptions set forth herein. Accordingly, the embodiments are merely described below, by referring to the figures, to explain aspects.

As used herein, the term "and/or" includes any and all combinations of one or more of the associated listed items. Expressions such as "at least one of," when preceding a list of elements, modify the entire list of elements and do not modify the individual elements of the list. For example, the expression, "at least one of a, b, and c," should be understood as including only a, only b, only c, both a and b, both a and c, both b and c, or all of a, b, and c.

Hereinafter, embodiments will be described in detail with reference to the accompanying drawings. Like reference numerals in the drawings denote like elements, and the size of each element in the drawings may be exaggerated for clarity and convenience of description. Embodiments described below are merely examples, and various modifications may be made from these embodiments.

Hereinafter, what is described as "above" or "on" may include those directly on, underneath, left, and right in contact, as well as above, below, left, and right in non-contact. The singular forms are intended to include the plural forms as well, unless the context clearly indicates otherwise. Also, when a part "includes" any element, it means that the part may further include other elements, rather than excluding other elements, unless otherwise stated.

The term "the" and the similar indicative terms may be used in both the singular and the plural. If there is no explicit description of the order of steps constituting a method or no contrary description thereto, these steps may be performed in an appropriate order, and are not limited to the order described.

In addition, the terms "... unit", "module", etc. described herein mean a unit that processes at least one function or operation, may be implemented as hardware or software, or may be implemented as a combination of hardware and software .

Connections of lines or connection members between elements shown in the drawings are illustrative of functional connections and/or physical or circuitry connections, and may be replaced in an actual device, or may be represented as additional various functional connections, physical connections, or circuitry connections.

The use of all examples or example terms is merely for describing the technical concept in detail, and the scope thereof is not limited by these examples or example terms unless limited by claims.

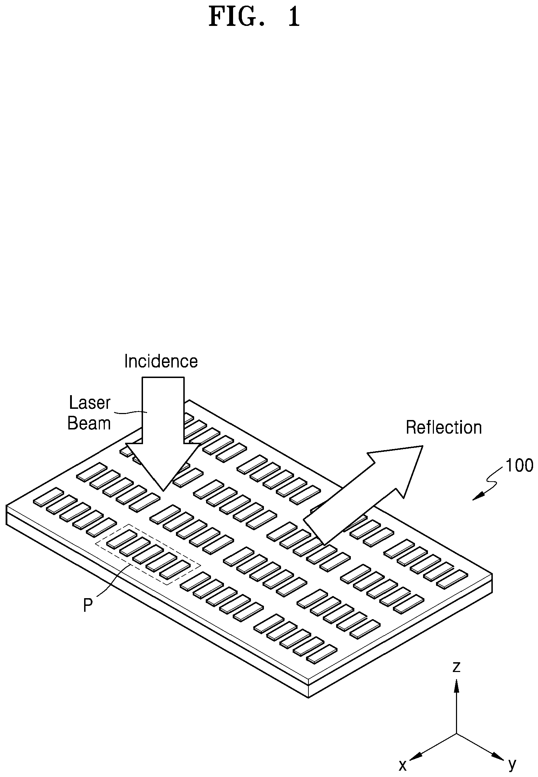

FIG. 1 is a perspective view illustrating a phase modulation device according to an embodiment.

Referring to FIG. 1, the phase modulation device 100 may include a plurality of pixels P arranged in a certain shape or pattern. The plurality of pixels P may be arranged in a two-dimensional or one-dimensional shape or pattern. Each of the pixels P may independently modulate a phase of incident light (a laser beam) by a change in a refractive index according to an applied voltage. Accordingly, the pixels P constituting the phase modulation device 100 may form a phase profile and control the phase profile, thereby emitting and steering a light incident on the phase modulation device 100 in a desired direction. The light incident on the phase modulation device 100 may have, for example, a wavelength of about 900 nm to about 1,000 nm. FIG. 1 illustrates a case where the phase modulation device 100 is a reflective phase modulation device, but embodiments are not limited thereto, and the phase modulation device 100 may also be a transmissive phase modulation device.

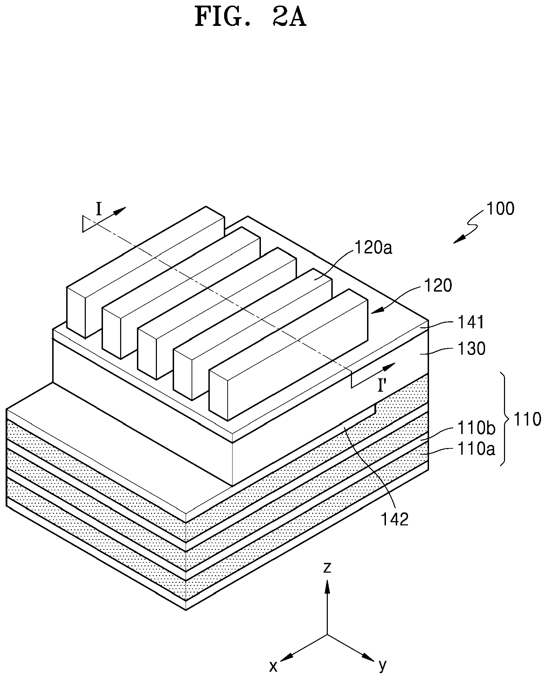

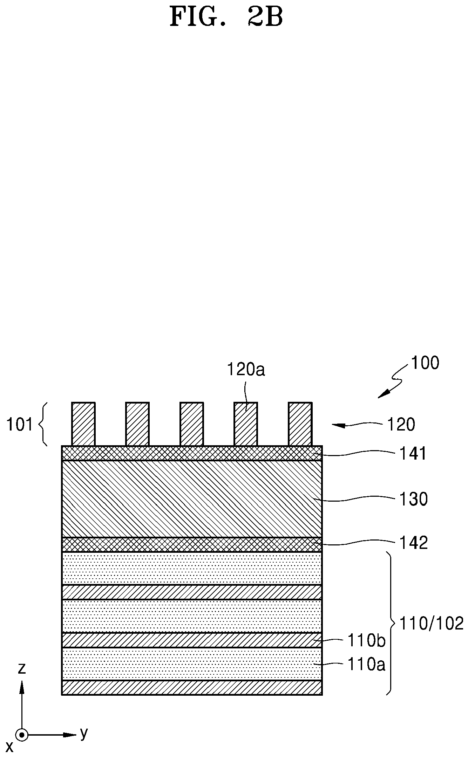

FIG. 2A is a perspective view illustrating the pixel P of the phase modulation device 100 shown in FIG. 1 according to an embodiment. FIG. 2B is a cross-sectional view taken along a line I-I' of FIG. 2A according to an embodiment.

Referring to FIGS. 2A and 2B, the phase modulation device 100 includes an upper reflective layer 101 onto which a light is incident, a lower reflective layer 102 provided in a lower portion of the upper reflective layer 101, an active layer 130 provided between the upper reflective layer 101 and the lower reflective layer 102, and a pair of electrodes 141 and 142 provided in upper and lower surfaces of the active layer 130.

A substrate may be provided in a lower portion of the lower reflective layer 102, and a semiconductor substrate (e.g., a silicon substrate) may be used as the substrate. However, the disclosure is not limited thereto. A thickness of the substrate may be determined in consideration of various factors, for example, a form factor and/or heat emission when the phase modulation device 100 is applied to a product.

The lower reflective layer 102 may include a distributed Bragg reflector (DBR) layer 110 in which at least one low refractive material layer 110a and at least one high refractive material layer 110b are alternately stacked. A material, thickness, etc. of each of the low refractive material layer 110a and the high refractive material layer 110b may be adjusted in various ways according to a reflectance design condition of the DBR layer 110. FIGS. 2A and 2B illustrate a case where the low refractive material layers 110a and the high refractive material layers 110b are alternately stacked three times. However, the disclosure is not limited thereto, and the number of times the low refractive material layers 110a and the high refractive material layers 110b are alternately and repeatedly stacked may be modified in various ways.

The high refractive material layer 110b may include a material having a refractive index greater than a refractive index of the low refractive material layer 110a. For example, the low refractive material layer 110a may include silicon oxide, but is not limited thereto. The high refractive material layer 110b may include silicon (Si). However, the high refractive material layer 110b is not limited thereto, and, for example, may include Ge, GaP, or InP. The thickness of the high refractive material layer 110b may be less than the thickness of the low refractive material layer 110a. For example, the thickness of the high refractive material layer 110b may be about 60 nm to about 90 nm. However, the disclosure is not limited thereto.

The active layer 130 is provided on the DBR layer 110. The active layer 130 may be configured to resonate and amplify the incident light between the lower reflective layer 102 and the upper reflective layer 101. The active layer 130 may include a single layer. The active layer 130 may include a material having a refractive index greater than a refractive index of the low refractive material layer 110a of the DBR layer 110. The active layer 130 may include a material having a thermo-optic coefficient greater than a thermo-optic coefficient of the low refractive material layer 110a of the DBR layer 110. The thermo-optic coefficient refers to a refractive index change of a material according to a temperature change thereof.

The active layer 130 may include, for example, a material having a refractive index and a thermo-optic coefficient greater than a refractive index and a thermo-optic coefficient of silicon oxide. For example, the active layer 130 may include silicon. However, the active layer 130 is not limited thereto, and may include, for example, Ge.

A thickness of the active layer 130 may vary depending on a wavelength of the incident light. The thickness of the active layer 130 may be greater than the thickness of the high refractive material layer 110b of the DBR layer 110. For example, when the thickness of the high refractive material layer 110b of the DBR layer 110 is about 60 nm to about 90 nm, the thickness of the active layer 130 may be greater than 90 nm.

The first electrode 141 and the second electrode 142 are respectively provided in the upper and lower surfaces of the active layer 130. The first and second electrodes 141 and 142 are electrically connected to the upper and lower surfaces of the active layer 130, respectively. The first and second electrodes 141 and 142 are provided to directly contact the upper and lower surfaces of the active layer 130, respectively.

The pair of first and second electrodes 141 and 142 may generate a Joule's heat by injecting a current into the active layer 130, and accordingly, a refractive index of the material (e.g., Si, Ge, etc.) constituting the active layer 130 may change, and thus, the phase of the incident light may be controlled. The first and second electrodes 141 and 142 may each include, for example, a doped semiconductor material. As an example, when the active layer 130 includes Si, the first and second electrodes 141 and 142 may each include n-doped Si. However, the disclosure is not limited thereto.

The upper reflective layer 101 is provided in an upper portion of the active layer 130. The upper reflective layer 101 may include a high contrast grating (HCG) layer 120 constituting an active meta surface. The HCG layer 120 may have a structure in which a plurality of grating elements 120a are periodically arranged on the upper surface of the active layer 130. The plurality of grating elements 120a may have substantially the same shape and dimension. A width and height of each grating element 120a may be less than the wavelength of the incident light. The height of each grating element 120a may be designed to have a predetermined reflectance with respect to the incident light. For example, the height of each grating element 120a may be designed to have a reflectance of 70% or more. The plurality of grating elements 120a may be arranged in one-dimension. An arrangement period of the plurality of grating elements 120a may be less than the wavelength of the incident light. Each of the grating elements 120a constituting the HCG layer 120 may include a high refractive index material (e.g., silicon).

In each pixel P of the phase modulation device 100 according to an embodiment, when the Joule's heat is generated by injecting a predetermined current into the active layer 130 through the first and second electrodes 141 and 142, a temperature of the active layer 130 is changed, and the refractive index of the active layer 130 is changed according to the temperature change of the active layer 130, and thus, the phase of the incident light may be modulated.

According to an embodiment, the active layer 130 provided between the upper reflective layer 101 and the lower reflective layer 102 includes the material (e.g., Si or Ge) having a high refractive index and a high thermo-optic coefficient, which may increase the change in the refractive index of the active layer 130 according to an external electrical signal, and accordingly, a large phase change may be obtained with low power consumption, thereby improving efficiency.

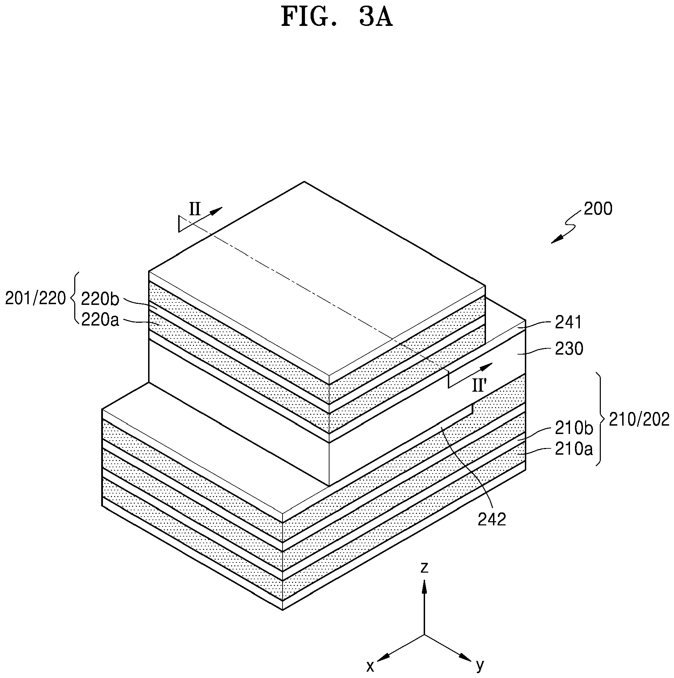

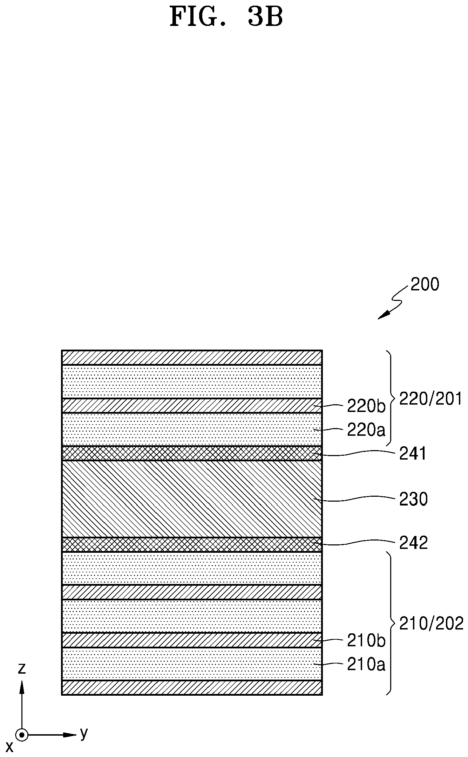

FIG. 3A is a perspective view illustrating a phase modulation device according to an embodiment. FIG. 3B is a cross-sectional view taken along a line II-II' of FIG. 3A according to an embodiment. For convenience, FIGS. 3A and 3B illustrate only one pixel P among the pixels P constituting the phase modulation device 100, and the same applies to the following drawings. Hereinafter, differences from the above-described embodiment are mainly described.

Referring to FIGS. 3A and 3B, a phase modulation device 200 includes an upper reflective layer 201 onto which a light is incident, a lower reflective layer 202 provided in a lower portion of the upper reflective layer 201, an active layer 230 provided between the upper reflective layer 201 and the lower reflective layer 202, and a pair of electrodes 241 and 242 provided in upper and lower surfaces of the active layer 130.

The lower reflective layer 202 may include a first DBR layer 210 in which at least one first low refractive material layer 210a and at least one first high refractive material layer 210b are alternately stacked. FIGS. 3A and 3B illustrate a case where the first low refractive material layers 210a and the first high refractive material layers 210b are alternately stacked three times. However, the disclosure is not limited thereto, and the number of times the first low refractive material layers 210a and the first high refractive material layers 210b are alternately and repeatedly stacked may be modified in various ways according to design conditions.

The first high refractive material layer 210b may include a material having a refractive index greater than a refractive index of the first low refractive material layer 210a. For example, the first low refractive material layer 21 0a may include silicon oxide, but is not limited thereto. The first high refractive material layer 210b may include silicon (Si). However, the first high refractive material layer 210b is not limited thereto, and, for example, may include Ge, GaP, or InP. The thickness of the first high refractive material layer 210b may be less than the thickness of the first low refractive material layer 210a. For example, the thickness of the first high refractive material layer 210b may be about 60 nm to about 90 nm, but is not limited thereto.

The active layer 230 is provided on the first DBR layer 210. The active layer 230 may include a material having a refractive index greater than a refractive index of the first low refractive material layer 210a of the first DBR layer 210. The active layer 230 may include a material having a thermo-optic coefficient greater than a thermo-optic coefficient of the first low refractive material layer 210a of the first DBR layer 210. The active layer 230 may include, for example, a material having a refractive index and a thermo-optic coefficient greater than a refractive index and a thermo-optic coefficient of silicon oxide. For example, the active layer 230 may include Si or Ge.

A thickness of the active layer 230 may be greater than a thickness of the first high refractive material layer 210b of the first DBR layer 210. For example, when the thickness of the first high refractive material layer 210b of the first DBR layer 210 is about 60 nm to about 90 nm, the thickness of the active layer 230 may be greater than 90 nm.

The first electrode 241 and the second electrode 242 are respectively provided in the upper and lower surfaces of the active layer 230. The first and second electrodes 241 and 242 are electrically connected to the upper and lower surfaces of the active layer 230, respectively. The first and second electrodes 241 and 242 are provided to directly contact the upper and lower surfaces of the active layer 230. The first and second electrodes 141 and 142 may include, for example, a doped semiconductor material. As a specific example, when the active layer 130 includes Si, the first and second electrodes 141 and 142 may each include n-doped Si. However, the disclosure is not limited thereto.

The upper reflective layer 201 is provided in an upper portion of the active layer 230. The upper reflective layer 201 may include a second DBR layer 220 in which at least one second low refractive material layer 220a and at least one second high refractive material layer 220b are alternately stacked. FIGS. 3A and 3B illustrate a case where the second low refractive material layers 220a and the second high refractive material layers 220b are alternately stacked two times, but the disclosure is not limited thereto, and the number of times the second low refractive material layers 220a and the second high refractive material layers 220b are alternately and repeatedly stacked may be modified in various ways according to design conditions. For phase control, the number of alternately stacked layers of the second DBR layer 220 may be less than the number of the first DBR layer 210.

The second high refractive material layer 220b may include a material having a refractive index greater than a refractive index of the second low refractive material layer 220a. For example, the second low refractive material layer 220a may include silicon oxide, but is not limited thereto. The second high refractive material layer 220b may include silicon (Si). However, the second high refractive material layer 220b is not limited thereto, and, for example, may include Ge, GaP, or InP. A thickness of the second high refractive material layer 220b may be less than the thickness of the second low refractive material layer 220a.

In the phase modulation device 200 according to an embodiment, the active layer 230 includes the material (e.g., Si or Ge) having a high refractive index and a high thermo-optic coefficient, which may increase a change in a refractive index of the active layer 230 according to an external electrical signal, and accordingly, a large phase change may be obtained with low power consumption, thereby improving efficiency.

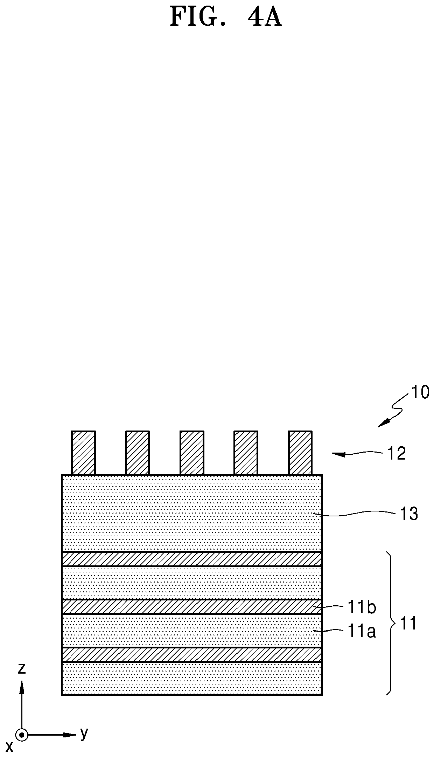

FIG. 4A illustrates a phase modulation device 10 according to a first comparative example.

Referring to FIG. 4A, the phase modulation device 10 includes an upper reflective layer, a lower reflective layer, and an active layer 13 provided between the upper reflective layer and the lower reflective layer. The lower reflective layer may include a DBR layer 11 in which at least one low refractive material layer 11a and at least one high refractive material layer 11b are alternately stacked.

The active layer 13 is provided on the DBR layer 11. The active layer 13 may include silicon oxide. Silicon oxide may have a refractive index and a thermo-optic coefficient less than a refractive index and a thermo-optic coefficient of Si or Ge. The upper reflective layer is provided on the active layer 13. The upper reflective layer includes an HCG layer 12 in which a plurality of grating elements are periodically arranged. The phase modulation device 10 shown in FIG. 4A may modulate a phase of an incident light by using a refractive index change due to a Joule's heat generated by applying an electrical signal to the HCG layer 12 or the active layer 13.

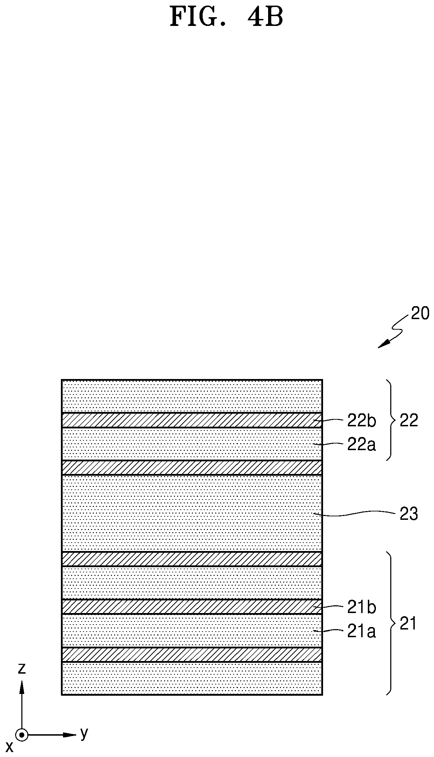

FIG. 4B illustrates a phase modulation device 20 according to a second comparative example.

Referring to FIG. 4B, the phase modulation device 20 includes an upper reflective layer, a lower reflective layer, and an active layer 23 provided between the upper reflective layer and the lower reflective layer. The lower reflective layer may include a first DBR layer 21 in which at least one first low refractive material layer 21a and at least one first high refractive material layer 21b are alternately stacked. Here, the first DBR layer 21 may be the same as the first DBR layer 210 shown in FIG. 3B, and thus, a description thereof is omitted.

The active layer 23 is provided on the first DBR layer 21. The active layer 23 may include silicon oxide. The upper reflective layer is provided on the active layer 23. The upper reflective layer may include a second DBR layer 22 in which at least one second low refractive material layer 22a and at least one second high refractive material layer 22b are alternately stacked. The second DBR layer 22 may be the same as the second DBR layer 220 shown in FIG. 3B, and thus, a description thereof is omitted. The phase modulation device 10 shown in FIG. 4B may modulate a phase of an incident light by using a refractive index change due to a Joule's heat generated by applying an electrical signal to the active layer 23.

In the phase modulation devices 10 and 20 according to the first and second comparative examples described above, each of the active layers 13 and 23 includes silicon oxide having a refractive index and a thermo-optic coefficient less than a refractive index and a thermo-optic coefficient of silicon. As described above, when each of the active layers 13 and 23 includes silicon oxide, the phase modulation devices 10 and 20 may have a problem in terms of a configuration of an optical module and power consumption.

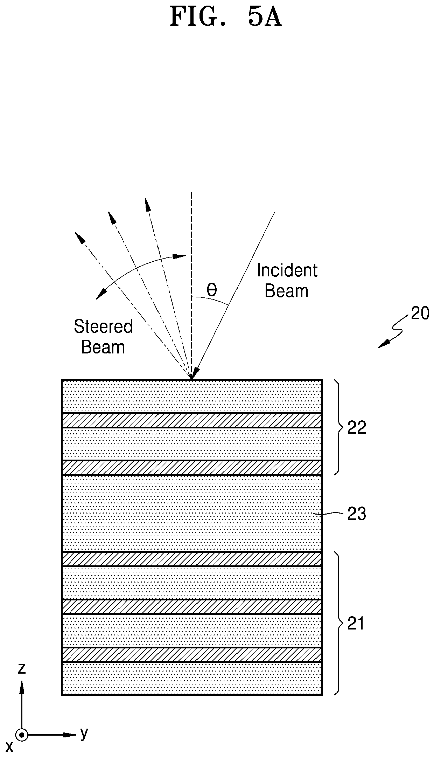

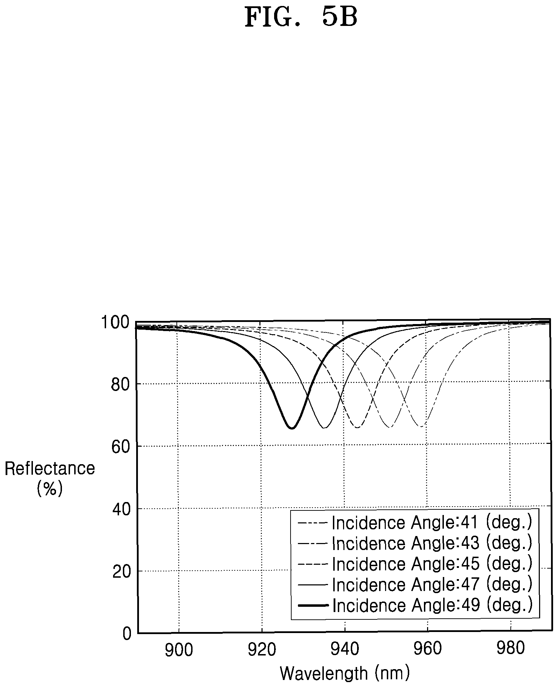

FIG. 5A illustrates the phase modulation device according to the second comparative example. FIG. 5B is a graph illustrating the phase modulation device 20 a reflectance spectrum according to a change in an incidence angle θ of an incident beam incident on the phase modulation device 20.

FIG. 5A illustrates a case where the incident beam is incident on the phase modulation device 20 with the incidence angle θ. The first DBR layer 21 includes three pairs of a first low refractive material layer SiO₂ and a first high refractive material layer Si, and the second DBR layer 22 includes two pairs of a second low refractive material layer SiO₂ and a second high refractive material layer Si. The active layer 23 includes SiO₂ with a thickness of 370 nm.

FIG. 5B illustrates the reflectance spectrum according to the change in the incidence angle θ of the incident beam incident on the phase modulation device 20 shown in FIG. 5A. The incidence angle θ is ±2 ° and ±4 ° with respect to 45 °. Referring to FIG. 5B, when the incidence angle θ is changed to 41 °, 43 °, 45 °, 47 °, and 49°, a resonance wavelength is changed to 959 nm, 951 nm, 943 nm, 936 nm, and 927 nm, respectively. That is, in the phase modulation device 20 including the active layer 23 including silicon oxide, when the incidence angle θ changed from 41 ° to 49 °, the resonance wavelength is changed by 32 nm from 959 nm to 927 nm. As described above, it may be seen that in the phase modulation device 20 including the active layer 23 including silicon oxide, when the incidence angle θ changes, the resonance wavelength greatly changes.

In general, in an operation of configuring a beam steering system by assembling a laser light source and a phase modulation device, the incidence angle θ of an incident beam incident from the laser light source may have a dispersion or range. In this case, when the resonance wavelength greatly changes according to the change in the incidence angle θ, a phase modulation may not occur. That is, the phase modulation occurs near the resonance wavelength. When the resonance wavelength greatly changes according to the change in the incidence angle θ, the resonance wavelength may not match a wavelength of the incident beam according to the change in the incidence angle θ. In this case, the phase modulation may not occur.

In the phase modulation device 20 including the active layer 23 including silicon oxide, power consumption may increase. Silicon oxide has a very small thermo-optic coefficient of about 5×10⁻⁷K⁻¹ at a wavelength of 940 nm and room temperature compared to silicon. Therefore, the refractive index change of the active layer 23 according to an external electrical signal is small, and as a result, the phase modulation device 20 using silicon oxide as the active layer 23 requires a high power consumption to obtain a desired phase change.

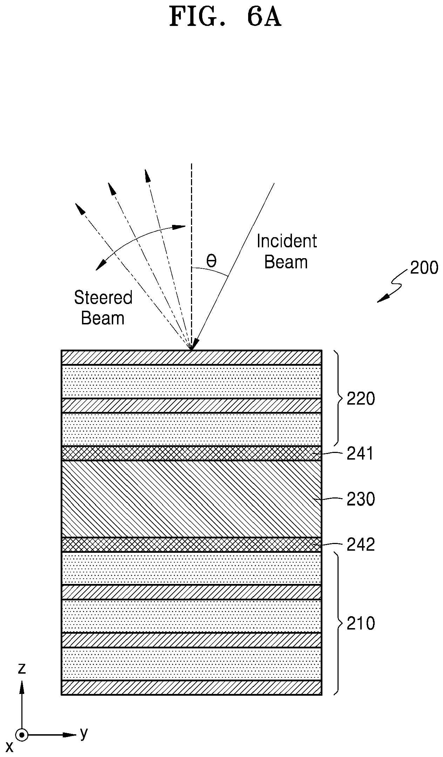

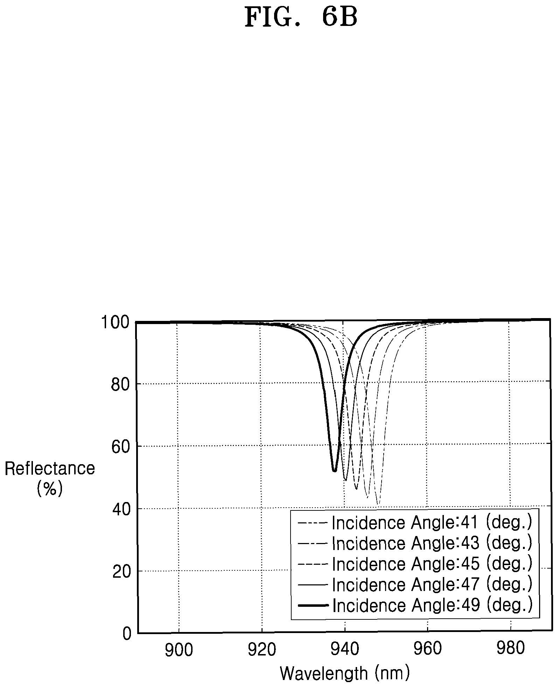

FIG. 6A illustrates a phase modulation device 200 according to an embodiment. FIG. 6B is a graph illustrating a reflectance spectrum according to a change in the incidence angle θ of an incident beam incident on the phase modulation device 200.

FIG. 6A illustrates a case where the incident beam is incident on the phase modulation device 200 with the incidence angle θ. The first DBR layer 210 includes three pairs of a first low refractive material layer SiO₂ and a first high refractive material layer Si, and the second DBR layer 220 includes two pairs of a second low refractive material layer SiO₂ and a second high refractive material layer Si. The active layer 230 includes SiO₂ with a thickness of 370 nm.

FIG. 6B illustrates the reflectance spectrum according to the change in the incidence angle θ of the incident beam incident on the phase modulation device 200 shown in FIG. 6A. The incidence angle θ is ±2 ° and ±4 ° with respect to 45 °. Referring to FIG. 6B, when the incidence angle θ is changed to 41 °, 43 °, 45 °, 47 °, and 49°, a resonance wavelength is changed to 948.5 nm, 945.5 nm, 943.5 nm, 940.5 nm, and 937.5 nm, respectively. That is, it may be seen that in the phase modulation device 200 including the active layer 230 including silicon, when the incidence angle θ changed from 41 ° to 49 °, the resonance wavelength is changed by 11 nm from 948.5 nm to 937.5 nm. As described above, it may be seen that in the phase modulation device 200 including the active layer 230 including silicon, when the incidence angle θ changes, the resonance wavelength changes less than in the phase modulation device 20 including the active layer 23 including silicon oxide. That is, it may be seen that in the phase modulation device 200 including the active layer 230 including silicon, a change of the resonance wavelength is less sensitive or non-sensitive to the change of the incidence angle θ. Therefore, when the phase modulation device 200 including the active layer 230 including silicon is combined with a laser light source to configure a beam steering system, robust characteristics against a change in the incidence angle θ of an incident beam incident from the laser light source may be implemented.

Silicon has a very large thermo-optic coefficient of about 1.8×10⁻⁴K⁻¹ at a wavelength of 940 nm and room temperature compared to silicon oxide, which shows a large refractive index change with a temperature change. Therefore, the refractive index change of the active layer 230 according to an external electrical signal is large, and as a result, the phase modulation device 200 using silicon as the active layer 230 may obtain a high phase change even with a low power consumption.

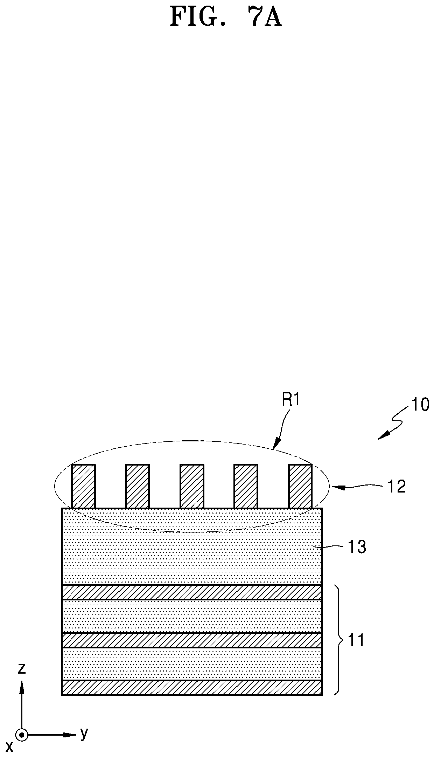

FIG. 7A is a diagram illustrating a region R1 in which a refractive index highly changes due to heating in the phase modulation device 10 according to the first comparative example. The HCG layer 12 includes Si, and the active layer 13 includes SiO₂.

Referring to FIG. 7A, when a Joule's heat is generated by applying a predetermined electrical signal to the HCG layer 12 or the active layer 13, the HCG layer 12 and the active layer 13 is heated, and thus, a refractive index thereof changes. As described above, because silicon oxide has a very low thermo-optic coefficient compared to silicon, the active layer 13 including silicon oxide does not involve a large refractive index change due to heating. Accordingly, the region R1 in which the refractive index highly changes due to heating may be formed only in the HCG layer 12.

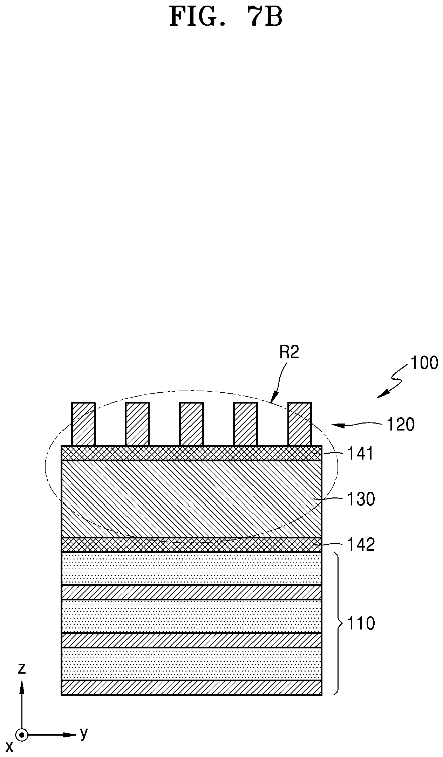

FIG. 7B is a diagram illustrating a region R2 in which a refractive index highly changes due to heating in the phase modulation device 100 according to an embodiment. The HCG layer 120 includes Si, and the active layer 130 includes Si.

Referring to FIG. 7B, when a Joule's heat is generated by injecting a predetermined current into the active layer 130 through a pair of first and second electrodes 141 and 142, the active layer 130 is heated, and the HCG layer 120 thereon may also be heated. Because silicon has a large thermo-optic coefficient compared to silicon oxide, the active layer 130 including silicon may involve a large refractive index change due to heating. Accordingly, the region R2 in which the refractive index highly changes due to heating may be formed in the active layer 130 and the HCG layer 120. When the refractive index of not only the active layer 130 but also the HCG layer 120 changes substantially due to heating, a phase of incident light may be more efficiently controlled.

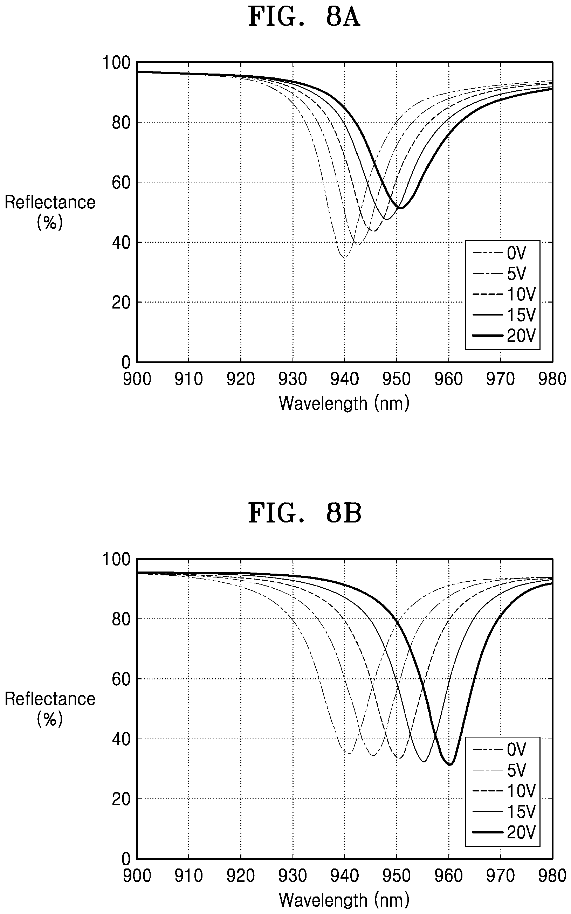

FIG. 8A is a graph illustrating simulation results regarding a reflectance of the SiO₂ active layer 13 according to an applied voltage in the phase modulation device 10 according to the first comparative example shown in FIG. 7A.

Referring to FIG. 8A, when the applied voltage is 0 V, a resonance wavelength is approximately 940 nm, a full width at half maximum (FWHM) is 11 nm, and a Q-factor is 86. As the applied voltage increases, a red shift of the resonance wavelength occurs. Specifically, when the applied voltage increases from 0 V to 20 V, the resonance wavelength increases from about 940 nm to about 950 nm, and thus, the red shift of approximately +10 nm may occur.

FIG. 8B is a graph illustrating simulation results regarding a reflectance of the Si active layer 130 according to an applied voltage in the phase modulation device 100 according to an embodiment shown in FIG. 7B.

Referring to FIG. 8B, when the applied voltage is 0 V, a resonance wavelength is approximately 940 nm, a FWHM is 12 nm, and a Q-factor is 80. When the applied voltage increases, a resonance wavelength red shift occurs. Specifically, when the applied voltage increases from 0 V to 20 V, the resonance wavelength increases from about 940 nm to about 960 nm, and thus, the red shift of approximately +20 nm may occur. As described above, a large red shift may occur at the same applied voltage in the Si active layer 130 compared to the SiO₂ active layer 13, which indicates that the efficiency and directivity of the phase modulation device 100 may be improved. Therefore, the phase modulation device 100 including the Si active layer 130 may implement the same efficiency and directivity as the phase modulation device 10 including the SiO₂ active layer 13 even with less power consumption.

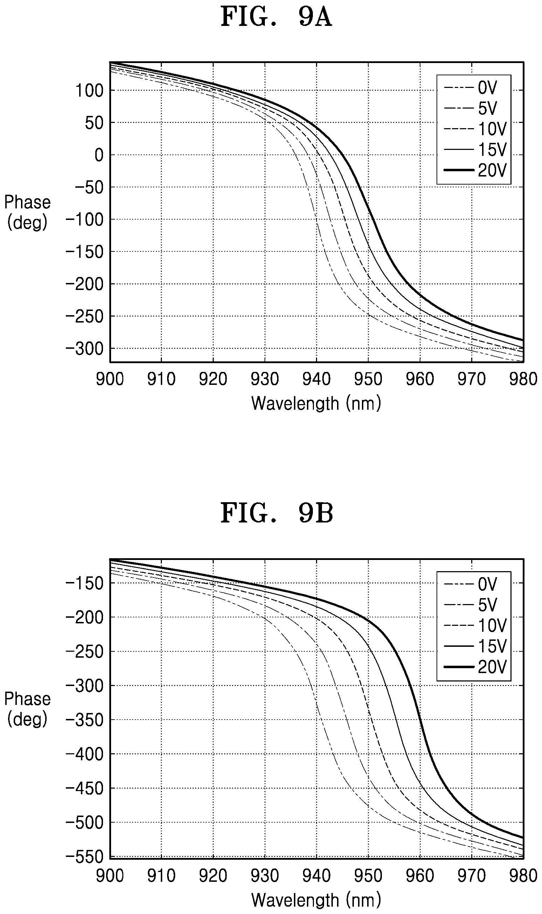

FIG. 9A is a graph illustrating simulation results regarding a reflection phase of the SiO₂ active layer 13 according to an applied voltage in the phase modulation device 10 according to the first comparative example shown in FIG. 7A. FIG. 9B is a graph illustrating simulation results regarding a reflection phase of the Si active layer 130 according to an applied voltage in the phase modulation device 100 according to an embodiment shown in FIG. 7B.

Referring to FIGS. 9A and 9B, it may be seen that because the red shift according to the applied voltage greatly increases in the Si active layer 130 compared to in the SiO₂ active layer 13, more phase changes occur in the Si active layer 130.

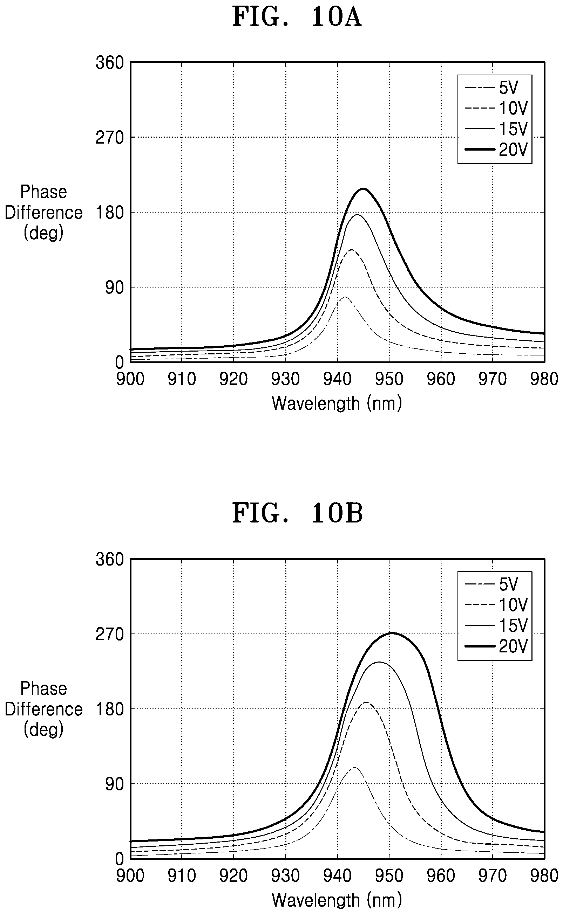

FIG. 10A is a graph illustrating simulation results regarding a reflection phase change in the SiO₂ active layer 13 in the phase modulation device 10 according to the first comparative example shown in FIG. 7A. FIG. 10B is a graph illustrating simulation results regarding a reflection phase change in the Si active layer 130 according to an applied voltage in the phase modulation device 100 according to an embodiment shown in FIG. 7B. FIGS. 10A and 10B illustrate phase changes according to the applied voltage compared to a phase when the applied voltage is 0 V.

Referring to FIGS. 10A and 10B, it may be seen that the SiO₂ active layer 13 has a maximum phase change of about 200°, whereas the Si active layer 130 has a maximum phase change of about 270°, which is greater than a maximum phase change of the SiO₂ active layer 13.

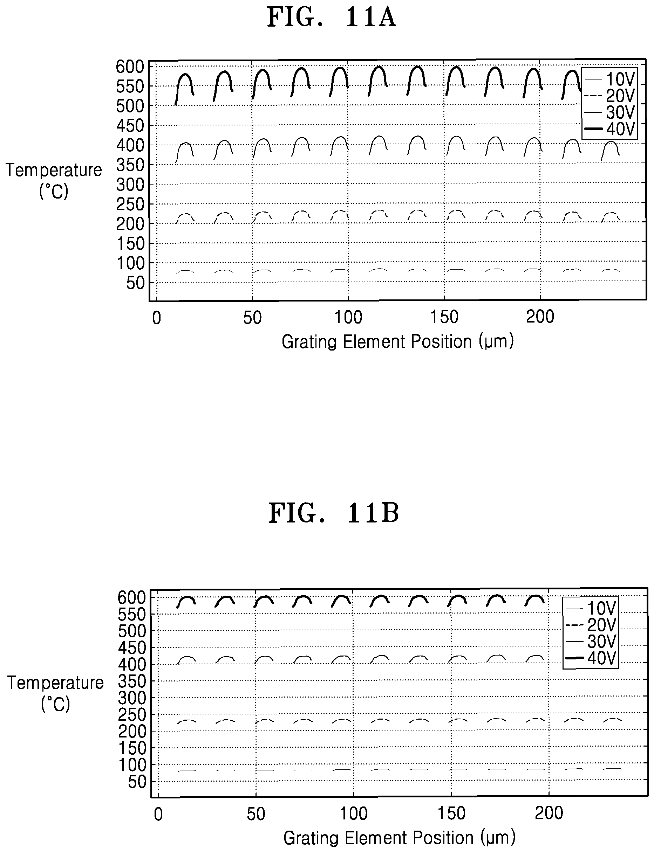

FIG. 11A is a graph illustrating simulation results regarding a temperature distribution for each grating element position of the HCG layer 12 in the phase modulation device 10 according to the first comparative example shown in FIG. 7A. FIG. 11A illustrates the temperature distribution of grating elements constituting the HCG layer 120 in a y-axis direction of FIG. 7A when heat is generated by applying a predetermined voltage to the HCG layer 120.

FIG. 11B is a graph illustrating simulation results regarding a temperature distribution for each grating element position of the HCG layer 120 in the phase modulation device 100 according to an embodiment shown in FIG. 7B. FIG. 11B illustrates the temperature distribution of the grating elements constituting the HCG layer 120 in a y-axis direction of FIG. 7B when heat is generated by applying a predetermined voltage to the HCG layer 120.

Referring to FIGS. 11A and 11B, it may be seen that the internal temperature of the Si grating elements constituting the HCG layer 120 is relatively uniform in the phase modulation device 100 according to an embodiment, compared to the phase modulation device 10 according to the first comparative example.

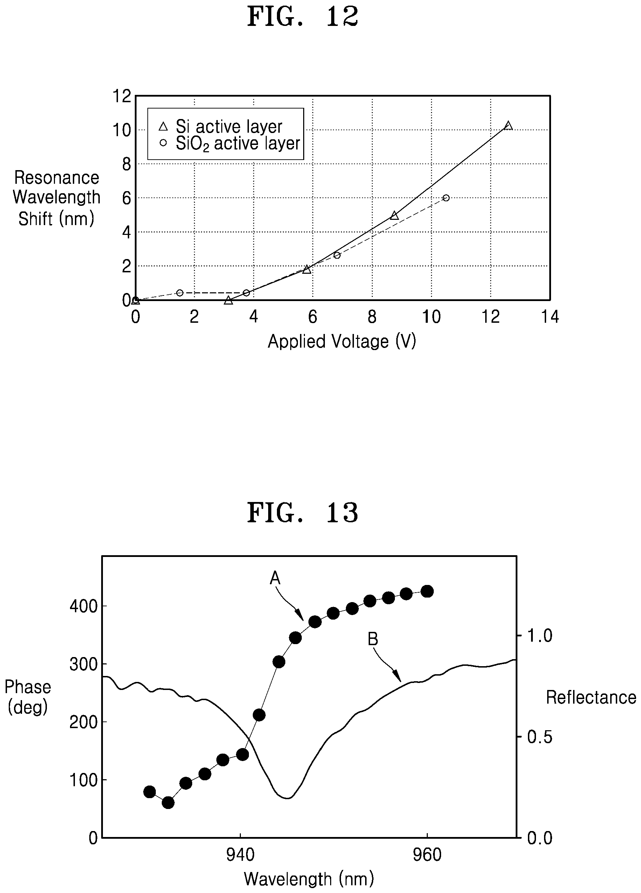

FIG. 12 is a graph illustrating experimental results regarding a comparison of a resonance wavelength shift according to an applied voltage between the SiO₂ active layer 13 of the phase modulation device 10 according to the first comparative example shown in FIG. 7A and the Si active layer 130 of the phase modulation device 100 according to an embodiment shown in FIG. 7B.

Referring to FIG. 12, when the voltage applied to the phase modulation device 10 according to the first comparative example and the phase modulation device 100 according to an embodiment is the same (e.g., 10 V), the resonance wavelength shift (a red shift) of the SiO₂ active layer 13 is measured as approximately 5 nm, and the resonance wavelength shift (a red shift) of the Si active layer 130 is measured as approximately 7 nm. Accordingly, it may be seen that the red shift of the Si active layer 130 is approximately 40 % greater than the red shift of the SiO₂ active layer 13 at the same applied voltage of 10 V. This indicates that the phase modulation device 100 including the Si active layer 130 may reduce power consumption required to implement the same red shift compared to the phase modulation device 10 including the SiO₂ active layer 13.

An active layer including a material (e.g., Si or Ge) having a refractive index and a thermo-optic coefficient greater than a refractive index and a thermo-optic coefficient of silicon oxide may have sufficiently an excellent resonance characteristics and high Q-factor without a significant loss with respect to an incident beam in a wavelength range of about 900 nm to about 1000 nm. Accordingly, a phase modulation device including the active layer including the material having the high refractive index and the high thermo-optic coefficient may be driven in an over-coupling region.

FIG. 13 is a graph illustrating experimental results regarding a phase spectrum and a reflectance spectrum of the phase modulation device 100 according to an embodiment shown in FIG. 7B. In FIG. 13, "A" represents the phase spectrum and "B" represents the reflectance spectrum. Referring to FIG. 13, it may be confirmed that the phase spectrum exists in an over-coupling region where a phase changes by more than 300° according to a wavelength.

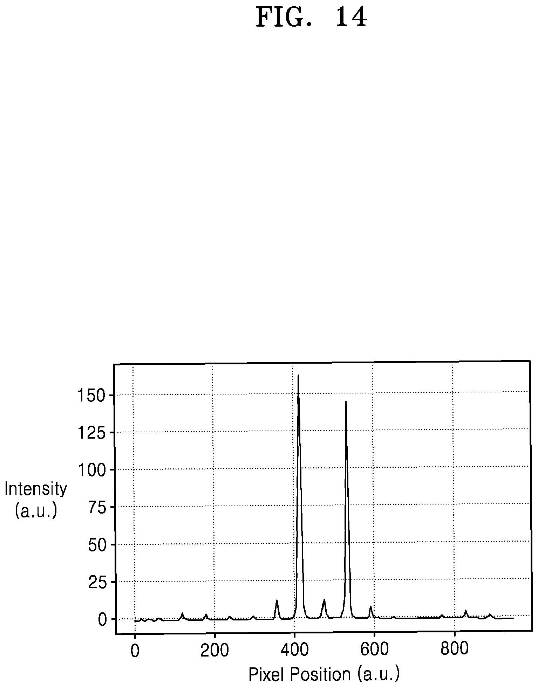

FIG. 14 is a graph illustrating a far-field distribution measured through beam steering in the phase modulation device 100 according to an embodiment shown in FIG. 7B. FIG. 14 illustrates the far-field distribution according to positions of the pixels P of the phase modulation device 100 shown in FIG. 1. Referring to FIG. 14, it may be seen that the phase modulation device 100 according to an embodiment may implement beam steering having a high directivity by using the Si active layer 130.

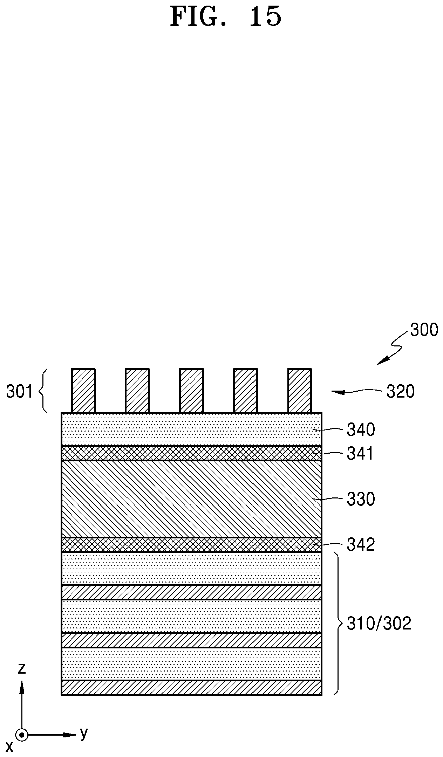

FIG. 15 illustrates a cross-section of a phase modulation device 300 according to an embodiment. The phase modulation device 300 shown in FIG. 15 is similar to the phase modulation device 100 shown in FIGS. 2A and 2B except that a protection layer 340 is formed on an upper surface of an active layer 330. Hereinafter, differences from the embodiment shown in FIGS. 2A and 2B are mainly described.

Referring to FIG. 15, the phase modulation device 300 includes a lower reflective layer 302, an upper reflective layer 301, the active layer 330 provided between the lower reflective layer 302 and the upper reflective layer 301, a pair of first and second electrodes 341 and 342 provided on upper and lower surfaces of the active layer 330, and the protection layer 340 provided between the active layer 330 and the upper reflective layer 301.

The lower reflective layer 302 may include a DBR layer 310 in which at least one low refractive material layer and at least one high refractive material layer are alternately stacked. The upper reflective layer 301 may include a HCG layer 320 having a structure in which a plurality of grating elements are periodically arranged on the upper surface of the active layer 330. The DBR layer 310 and the HCG layer 320 are respectively the same as the DBR layer 110 and the HCG layer 120 of the embodiment shown in FIGS. 2A and 2B, and thus, detailed descriptions thereof are omitted.

The active layer 330 is provided between the DBR layer 310 and the HCG layer 320. The active layer 330 may include a material having a refractive index greater than a refractive index of the low refractive material layer of the DBR layer 310. The active layer 330 may include a material having a thermo-optic coefficient greater than a thermo-optic coefficient of the low refractive material layer of the DBR layer 310. The active layer 330 may include, for example, a material having a refractive index and a thermo-optic coefficient greater than a refractive index and a thermo-optic coefficient of silicon oxide. For example, the active layer 330 may include Si or Ge. A thickness of the active layer 330 may be greater than a thickness of the high refractive material layer of the DBR layer 310.

The first electrode 341 and the second electrode 342 are respectively provided on the upper and lower surfaces of the active layer 330. The first and second electrodes 341 and 342 are electrically connected to the upper and lower surfaces of the active layer 330, respectively. The first and second electrodes 341 and 342 may each include, for example, a doped semiconductor material. As a specific example, when the active layer 330 includes Si, the first and second electrodes 341 and 342 may include n-doped Si. The first and second electrodes 341 and 342 are respectively the same as the first and second electrodes 141 and 142 of the embodiment shown in FIGS. 2A and 2B, and thus, detailed descriptions thereof are omitted.

The protection layer 340 is provided between the active layer 330 and the HCG layer 320. The protection layer 340 may serve to prevent a device from peeling off during annealing of an active layer material (e.g., Si or Ge) for generating a Joule's heat.

The protection layer 340 may include, for example, at least one of silicon oxide, silicon nitride, aluminum oxide, hafnium oxide, and titanium oxide. However, the disclosure is not limited thereto. A thickness of the protection layer 340 may be about 20 nm to about 200 nm, but this is merely an example.

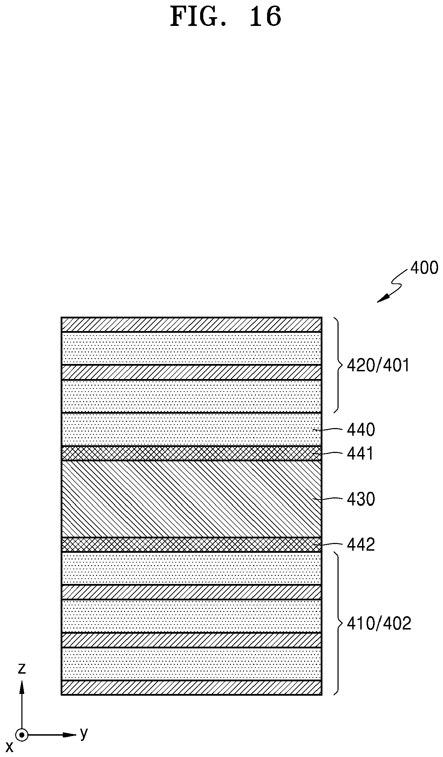

FIG. 16 illustrates a cross-section of a phase modulation device 400 according to an embodiment. The phase modulation device 400 shown in FIG. 16 is similar to the phase modulation device 200 shown in FIGS. 3A and 3B except that a protection layer 440 is formed on an upper surface of an active layer 430. Hereinafter, differences from the embodiment shown in FIGS. 3A and 3B are mainly described.

Referring to FIG. 16, the phase modulation device 400 includes a lower reflective layer 402, an upper reflective layer 401, the active layer 430 provided between the lower reflective layer 402 and the upper reflective layer 401, a pair of first and second electrodes 441 and 442 provided on upper and lower surfaces of the active layer 430, and the protection layer 440 provided between the active layer 430 and the upper reflective layer 401.

The lower reflective layer 402 may include a first DBR layer 410 in which at least one first low refractive material layer and at least one first high refractive material layer are alternately stacked. The upper reflective layer 401 may include a second DBR layer 420 in which at least one second low refractive material layer and at least one second high refractive material layer are alternately stacked. The first DBR layer 410 and the second DBR layer 420 are respectively the same as the first DBR layer 210 and the second DBR layer 220 of the embodiment shown in FIGS. 3A and 3B, and thus, detailed descriptions thereof are omitted.

The active layer 430 is provided between the first DBR layer 410 and the second DBR layer 420. The active layer 430 may include a material having a refractive index greater than a refractive index of the low refractive material layer of the first DBR layer 410. The active layer 430 may include a material having a thermo-optic coefficient greater than thermo-optic coefficient of the low refractive material layer of the first DBR layer 410. For example, the active layer 430 may include Si or Ge. A thickness of the active layer 430 may be greater than a thickness of the high refractive material layer of the first DBR layer 410.

The first electrode 441 and the second electrode 442 are respectively provided on the upper and lower surfaces of the active layer 430. The first and second electrodes 441 and 442 are electrically connected to the upper and lower surfaces of the active layer 430, respectively. The first and second electrodes 441 and 442 may each include, for example, a doped semiconductor material. As a specific example, when the active layer 430 includes Si, the first and second electrodes 441 and 442 may each include n-doped Si. The first and second electrodes 441 and 442 are respectively the same as the first and second electrodes 241 and 242 of the embodiment shown in FIGS. 3A and 3B, and thus, detailed descriptions thereof are omitted.

The protection layer 440 is provided between the active layer 430 and the second DBR layer 420. The protection layer 440 may include, for example, at least one of silicon oxide, silicon nitride, aluminum oxide, hafnium oxide, and titanium oxide. However, the disclosure is not limited thereto. A thickness of the protection layer 440 may be about 20 nm to about 200 nm, but this is merely an example.

The phase modulation devices 100, 200, 300, and 400 according to the embodiments described above may be applied to a beam steering system steering an incident laser beam in a desired direction.

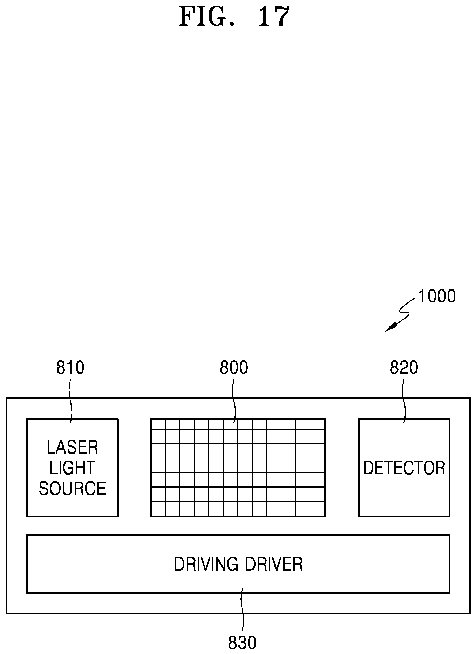

FIG. 17 illustrates a beam steering system 1000 according to an embodiment. Referring to FIG. 17, the beam steering system 1000 may include a laser light source 810 emitting a laser beam of a predetermined wavelength, a phase modulation device 800 steering the incident laser beam, a detector 820 detecting the steered laser beam, and a driving driver 830. The driving driver 830 may include a driving circuit driving the laser light source 810, the phase modulation device 800, and the detector 820.

The laser light source 810 may emit the laser beam having a wavelength of about 900 nm to about 1000 nm. As the laser light source 810, for example, a laser diode may be used. However, this is merely an example. The laser beam emitted from the laser light source 810 is incident on the phase modulation device 800. The phase modulation device 800 steers the laser beam in a desired direction by modulating a phase of the incident laser beam and emitting the incident laser beam. The phase modulation device 800 may be any one of the phase modulation devices 100, 200, 300, and 400 according to the embodiments described above. When the laser beam steered by the phase modulation device 800 is emitted to an object and reflected, the detector 820 may detect the reflected laser beam.

The beam steering system 1000 described above may be applied to various electronic apparatuses such as a three-dimensional (3D) depth camera that obtains distance information for each direction, a depth sensor, a 3D sensor, and light detection and ranging (LiDAR).

According to the embodiment, an active layer of a phase modulation device include a material (e.g., Si or Ge) having a refractive index and a thermo-optic coefficient greater than a refractive index and a thermo-optic coefficient of silicon oxide, which may increase the change in a refractive index of the active layer according to an external electrical signal, and accordingly, a large phase change may be obtained with low power consumption, thereby improving efficiency. Although the embodiment has been described above, this is merely an example, and various modifications are possible therefrom to those skilled in the art.

It should be understood that embodiments described herein should be considered in a descriptive sense only and not for purposes of limitation. Descriptions of features or aspects within each embodiment should typically be considered as available for other similar features or aspects in other embodiments. While one or more embodiments have been described with reference to the figures, it will be understood by those of ordinary skill in the art that various changes in form and details may be made therein without departing from the scope as defined by the following claims.

## Claims

1. A phase modulation device comprising:
an upper reflective layer onto which incident light is incident;
a lower reflective layer provided on a lower portion of the upper reflective layer;
an active layer provided between the upper reflective layer and the lower reflective layer;
a first electrode connected to an upper surface of the active layer; and
a second electrode connected to a lower surface of the active layer,
wherein the lower reflective layer comprises a first distributed Bragg reflector, DBR, layer comprising at least one first low refractive material layer and at least one first high refractive material layer that are alternately stacked,
wherein the at least one first low refractive material layer has a first refractive index and the at least one first high refractive material layer has a second refractive index that is greater than the first refractive index, and
wherein the active layer comprises a material having a third refractive index greater than the first refractive index of the at least one first low refractive material layer.

2. The phase modulation device of claim 1, wherein the active layer comprises a material having a first thermo-optic coefficient that is greater than a second thermo-optic coefficient of the at least one first low refractive material layer.

3. The phase modulation device of claim 1 or 2, wherein the phase modulation device is configured to change a refractive index of the active layer based on a current injected into the active layer through the first and second electrodes.

4. The phase modulation device of any preceding claim, wherein the active layer comprises Si or Ge.

5. The phase modulation device of any preceding claim, wherein a thickness of the active layer is greater than a thickness of the at least one first high refractive material layer.

6. The phase modulation device of any preceding claim, wherein the upper reflective layer comprises a high contrast grating, HCG, layer.

7. The phase modulation device of any preceding claim, wherein the upper reflective layer comprises a second DBR layer,
wherein the second DBR layer comprises at least one second low refractive material layer and at least one second high refractive material layer that are alternately stacked, and
wherein the at least one second low refractive material layer has a fourth refractive index and the at least one second high refractive material layer has a fifth refractive index that is greater than the fourth refractive index.

8. The phase modulation device of claim 7, wherein a number of alternately stacked layers in the second DBR layer is less than a number of alternately stacked layers in the first DBR layer.

9. The phase modulation device of any preceding claim, further comprising a protection layer provided between the upper reflective layer and the active layer.

10. The phase modulation device of claim 9, wherein the protection layer comprises at least one of silicon oxide, silicon nitride, aluminum oxide, hafnium oxide, and titanium oxide.

11. The phase modulation device of claim 9 or 10, wherein a thickness of the protection layer is in a range of 20 nm to 200 nm.

12. The phase modulation device of any preceding claim, wherein a wavelength of the incident light is in a range of 900 nm to 1,000 nm.

13. An electronic apparatus comprising:
a laser light source configured to emit light of a predetermined wavelength; and
a phase modulation device according to any preceding claim configured to modulate a phase of the light of the predetermined wavelength that is incident thereon from the laser light source.

14. The electronic apparatus of claim 13, wherein the predetermined wavelength is in a range of 900 nm to 1,000 nm.
